# EUROPEAN PATENT SPECIFICATION

(11) **EP 1 895 823 B1**
(45) Date of publication and mention of the grant of the patent: **09.02.2011**
(21) Application number: 07114860.5
(22) Date of filing: 23.08.2007
(51) Int. Cl.: H05K 7/14, H01R 12/58

(54) **Circuit Board Housing Structure**
Leiterplattengehäuseanordnung
Structure de logement de carte de circuit

(30) Priority: 29.08.2006 JP 2006231824; 29.08.2006 JP 2006232156
(43) Date of publication of application: 05.03.2008
(73) Proprietor: Keihin Corporation, Takanezawa-machi Shioya-gun Tochigi 329-1233 (JP)
(72) Inventor: Tsukahara, Morifumi, Shioy-gun, Tochigi 329-1233 (JP)
(74) Representative: Rupp, Christian

(56) References cited:
- EP-A- 0 575 892
- WO-A-01/87029
- DE-A1- 3 908 481
- JP-A- 10 208 798

## Description

### BACKGROUND OF THE INVENTION

### Field of the Invention

The present invention relates to a circuit board housing structure which holds a circuit board therein with connector pins attached thereto.

### Description of the Related Art

For a conventional circuit board housing structure, there has been known a structure in which a case holds a printed circuit board with electronic parts mounted thereon (see, for example, Japanese unexamined patent publication No. H10-208798, paragraph 0021 and FIG. 1). In this structure, connector pins (press-fitting pins) supported by a contact housing are joined to the printed circuit board at through-holes formed in one end portion of the printed circuit board by press-fitting. Also in this structure, a circuit pattern on the printed circuit board and the connector pins are electrically connected by press-fitting, while the connector pins cantilever the printed circuit board on the contact housing in the case.

With this configuration of the circuit board housing structure, as compared with a structure in which connector pins are welded to a printed circuit board, an assembling operation of the connector pins to the printed circuit board becomes easier. Since no welding is performed, i.e., no lead (Pb) is used, environmental pollutants can be also reduced.

In general, heat is likely to be held in small connector parts, due to heat generation by electronic parts mounted on the circuit board in the case and by an external environment, which may result in thermal expansion of the case. Since the printed circuit board abuts the contact housing (seating) in the circuit board housing structure described above, the printed circuit board suffers stress from the seating caused by thermal expansion, with the seating pushing the printed circuit board. As a result, reliability of electrical connections between the through-holes and the connector pins may become poor. Especially, even though the connector pins are not completely detached from the through-holes, electric characteristics may be altered, since a sufficient holding power in a diametrical direction cannot be obtained. As a result, desired impedance matching may not be obtained.

In addition, since the printed circuit board is cantilevered by the connector pins in this circuit board housing structure, when the circuit board housing structure suffers impact or vibration, the printed circuit board may be warped or misaligned. Especially in the case of the circuit board housing structure mounted on a vehicle, these defects may become notable due to vibration of the vehicle body. In order to prevent such warping and the like of the printed circuit board, the above-mentioned patent document introduces support stages on a bottom face of the case for supporting the printed circuit board. However, these support stages prevent the printed circuit board from warping only in a direction towards the bottom face of the case. In other words, the support stages cannot prevent the printed circuit board from warping in a direction away from the support stages. Despite this, the printed circuit board is demanded to prevent even from slight warping, under a recent situation where the circuit pattern of the printed circuit board tends to become finer.

Therefore, it would be desirable to provide a circuit board housing structure exhibiting thermally stable electric characteristics, as compared with the conventional circuit board housing structures. It would be also desirable to provide a circuit board housing structure which surely prevents warping of the circuit board against impact and vibration.

### SUMMARY OF THE INVENTION

In one aspect of the present invention, there is provided a circuit board housing structure according to claim 1.

With this configuration, the circuit board is supported in the case by the connector pins alone. Therefore, even when the case undergoes thermal expansion, it becomes possible to prevent the circuit board and the case from interfering with each other. As a result, change in electric characteristics which may otherwise occur by thermal expansion of the case can be prevented.

It is preferred that the circuit board is movable within a non-disengageable range that does not allow the insertion hole of the circuit board to disengage from the larger diameter portion of the connector pin.

With this configuration, insertion hole is not allowed to disengage from the larger diameter portion. Therefore, not only when the case undergoes thermal expansion but also when the case suffers impact, it becomes possible to prevent the circuit board and the case from interfering with each other. As a result, change in electric characteristics which may otherwise occur by thermal expansion of the case or impact on the case can be prevented.

It is preferred that the non-disengageable range is a range in which the circuit board does not interfere with any of the case body and the lid in an axial direction of the connector pin, even when at least one of the circuit board, the connector pin, the case body and the lid undergoes thermal expansion.

According to this configuration, based on experiments or simulations performed in advance, the circuit board housing structure can be made in such a manner that the non-disengageable range does not allow the circuit board to interfere with any of the case body and the lid in the axial direction of the connector pin, even when the case undergoes thermal expansion. As a result, change in electric characteristics which may otherwise occur by thermal expansion of the case can be surely prevented.

It is also preferred that the non-disengageable range is a range in which the holding power between the insertion hole of the circuit board and the larger diameter portion of the connector pin gives contact resistance therebetween that falls within a specific range.

According to this configuration, based on experiments or simulations performed in advance, the circuit board housing structure can be made in such a manner that the non-disengageable range allows the holding power between the insertion hole and the larger diameter portion of the connector pin gives contact resistance therebetween that falls within a specific range. As a result, a change in electric characteristics which may occur by thermal expansion of the case or impact on the case can be suppressed within allowable limits.

It is also preferred that at least one of the case body and the lid is provided with a limiting member for limiting a movement of the circuit board within the non-disengageable range.

With this configuration, the limiting member prevents the insertion hole from disengaging from the larger diameter portion. Therefore, not only when the case undergoes thermal expansion, but also when the case suffers impact, it becomes possible to prevent the circuit board and the case from interfering with each other. As a result, a change in electric characteristics which may otherwise occur by thermal expansion of the case or impact on the case can be prevented.

Accordingly, in this circuit board housing structure, the connection portion between the connector pins and the insertion holes does not suffer stress which may otherwise be caused by the case body or the lid by heat or impact, the holding power between the connector pins and the insertion holes can be kept nearly constant, and as compared with the conventional case, reliability of electrical connections can be improved.

It is also preferred that, the circuit board further has a second insertion hole on the other end portion of the circuit board, in which a larger diameter portion of a pin member having the same shape as that of the connector pin is inserted to thereby support the circuit board in the case.

In this circuit board housing structure, one end portion of the circuit board held in the case is supported by the case through the connector pins. The other end portion of the circuit board is supported by the case through the pin member. Since the circuit board is supported at both end portions, the circuit board is prevented from being warped.

In addition, since both end portions are supported by the connector pins and the pin member, unlike the conventional circuit board housing structure (for example, see the above-mentioned patent document), it is not necessary to provide the case with a support stage for supporting the circuit board. As a result, in this circuit board housing structure, a space in the case can be efficiently utilized. Accordingly, in the circuit board housing structure with no support stages, a structure of the case can be made simpler, and thus a production of the case can be facilitated.

Further in this circuit board housing structure, the connector pin and the pin member have the same shape. Therefore, by arranging the connector pins and the pin member on a same plane in the case, one end portion of the circuit board supported by the connector pins and the other end portion of the circuit board supported by the pin member are easily leveled to each other. Specifically, by arranging the connector pins and the pin member on the bottom face of the case, the circuit board can be easily arranged in parallel with the bottom face of the case.

In this circuit board housing structure, the same member can be used for the connector pins and the pin member. Therefore, a production cost of the circuit board housing structure can be reduced, and production efficiency can be improved.

Also in this circuit board housing structure, the pin member connected to the other end portion of the circuit board can be made so as not to be electrically connected to the circuit pattern formed on the circuit board.

In this circuit board housing structure, the pin member is not electrically connected to the circuit pattern of the circuit board. Therefore, the pin member can be arranged regardless of the configuration of the circuit pattern. As a result, design freedom of the circuit pattern on the circuit board is enhanced.

Further in this circuit board housing structure, it is preferred that, on inner faces of lateral walls of the case, ribs for positioning the circuit board are formed, and in the rim of the circuit board, recess portions are formed at positions corresponding to the ribs, each of which recess portion has a cross section corresponding to a cross section of the rib so as to accommodate the rib.

In this circuit board housing structure, by accommodating the rib of the case in the recess portion of the circuit board, the circuit board is properly positioned relative to the case. As a result, the circuit board is properly positioned relative to the connector pins and the pin member, which facilitates connections of the connector pins and the pin member to the circuit board by press-fitting.

### BRIEF DESCRIPTION OF THE DRAWINGS

The various aspects, other advantages and further features of the present invention will become more apparent by describing in detail illustrative, non-limiting embodiments thereof with reference to the accompanying drawings.
FIG. 1 is a perspective view for illustrating a configuration of a circuit board housing structure according to a first embodiment.
FIG. 2A is a cross-sectional view taken along a line A-A in FIG. 1, FIG. 2B is an enlarged view of a part of FIG. 2A (showing a limited state), and FIG. 2C is an enlarged view of a part of FIG. 2B (showing a connector pin).
FIG. 3 is a cross-sectional view taken along a line B-B in FIG. 1.
FIG. 4 shows diagrams explaining a positioning of a printed circuit board in a case body.
FIG. 5A is a cross-sectional view taken along the line A-A in FIG. 1 when a printed circuit board moves upward in a case, and FIG. 5B is a cross-sectional view taken along the line A-A in FIG. 1 when the printed circuit board moves downward in the case.
FIG. 6A is a graph showing a transition of a holding power in accordance with a displacement from a board standard position, and FIG. 6B is a graph showing a transition of contact resistance in accordance with a displacement from the board standard position.
FIG. 7 is a perspective view for illustrating a configuration of a circuit board housing structure according to a second embodiment.
FIG. 8 is a top view of a circuit board housing structure of the second embodiment showing a state in which a lid of the case is removed.
FIG. 9 is a cross-sectional view taken along a line C-C in FIG. 7.
FIG. 10A is a cross-sectional view taken along a line D-D in FIG. 7, FIG. 10B is a cross-sectional view taken along a line E-E in FIG. 7, and FIG. 10C is a partially cross-sectional view showing a state in which a connector pin or a pin member is fixed to the printed circuit board.

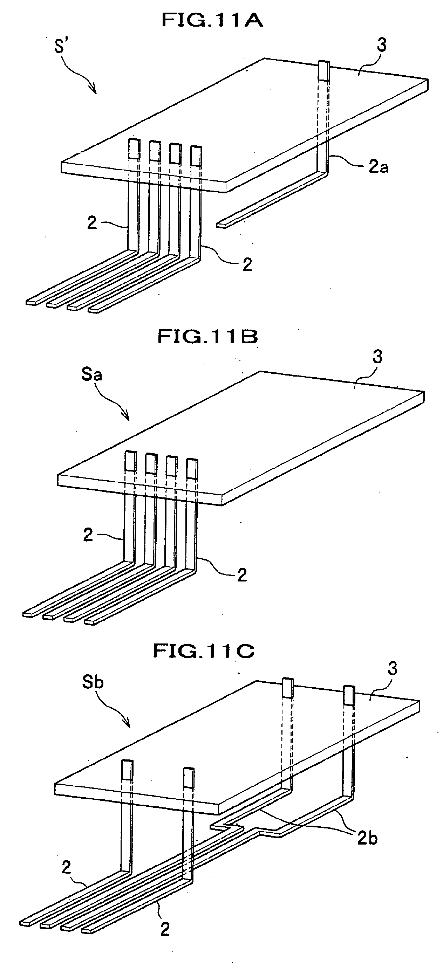

FIG. 11A is a schematic view of a part of the circuit board housing structure according to the second embodiment showing a state in which the connector pins and the pin member are fixed to the printed circuit board, FIG. 11B is a schematic view of a part of the conventional circuit board housing structure according to a comparative embodiment showing a state in which the connector pins are fixed to the printed circuit board, and FIG. 11C is a schematic view of a part of the conventional circuit board housing structure according to another comparative embodiment showing a state in which the connector pins are fixed to the printed circuit board.

### DETAILED DESCRIPTION OF THE EXEMPLARY EMBODIMENTS

Embodiments of the present invention will be described in detail below with reference to the accompanying drawings.

### (First embodiment)

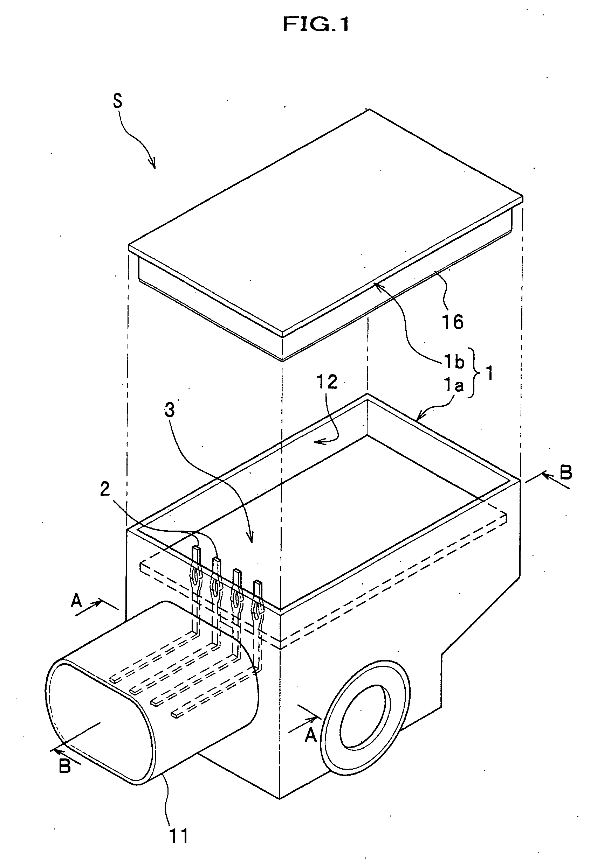

First, a circuit board housing structure according to a first embodiment of the present invention will be described in detail with reference to FIGs. 1 - 6.

As shown in FIG. 1, a circuit board housing structure S includes: a case 1 including a case body 1a and a lid 1b with a fitting protruding portion 16 that fits in an opening 12 of the case body 1a; connector pins 2 supported by the case body 1a; and a printed circuit board 3 on which electronic parts (not shown) are mounted and a specific circuit pattern is formed. It should be noted that the printed circuit board 3 corresponds to "circuit board".

As shown in FIGs. 1 - 3, the case body 1a is in a shape of a rectangle when seen as a plan view, and on an outer face on one short side of the rectangle (i.e., outer face of one of narrow lateral walls), a cylindrical connector 11 for connecting a harness connector (not shown) is provided. On an upper side of the case body 1a (upper side in FIG. 1), the opening 12 is formed which is to be closed with the lid 1b (see FIG. 1). When the case body 1a is closed with the lid 1b, an approximate rectangular parallelepiped is formed, in which the printed circuit board 3 and the connector pins 2 are held.

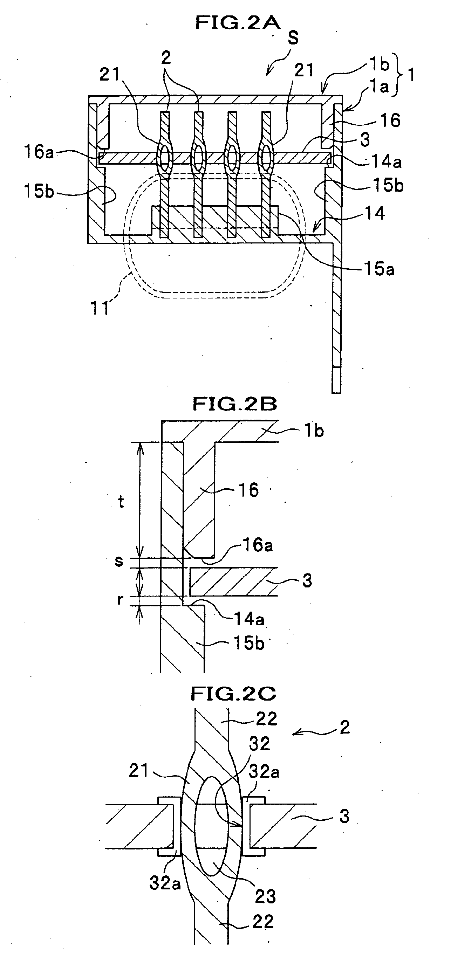

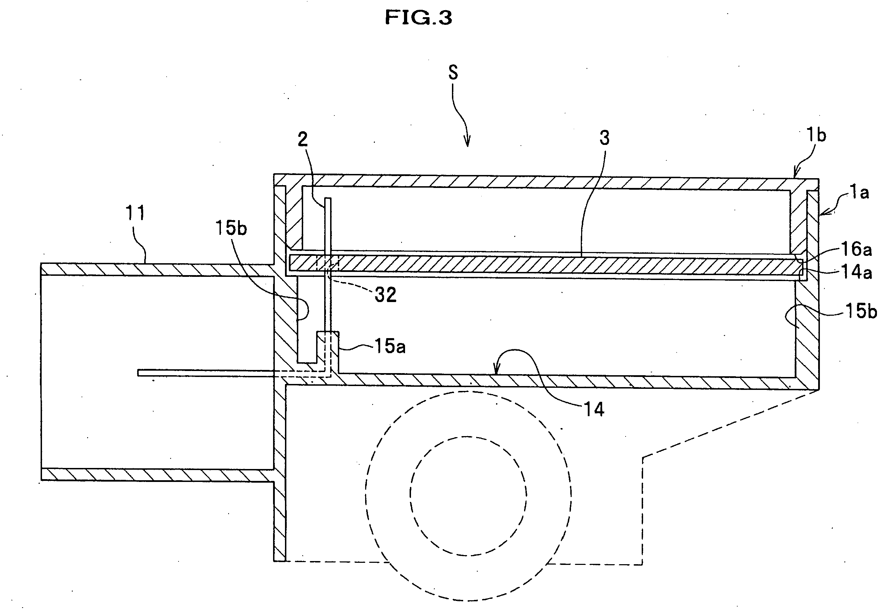

As shown in FIG. 2A, on a bottom face 14 of the case body 1a, a support portion 15a for holding the connector pins 2 in the case body 1a is formed. The support portion 15a is in a shape of a bar extending on the bottom face 14 of the case body 1a along the inner face on the short side (inner face of the narrow lateral wall) with the connector 11 (see FIG. 3).

In an inner periphery (inner faces of the lateral walls) of the case body 1a, a step-shaped limiting member 15b for limiting a downward movement of the circuit board 3 is formed. In this embodiment, the limiting member 15b is integrally formed with the case body 1a, but a strip-shaped body may be provided along the inner periphery.

Meanwhile, as shown especially in FIG. 2B, a distance r is provided between a limiting face 14a of the limiting member 15b and a lower face of the circuit board 3. On the other hand, a distance s is provided between an upper face of the circuit board 3 and a limiting face 16a of the fitting protruding portion (limiting member) 16. Therefore, the circuit board 3 is movable upward by the distance s and downward by the distance r, in FIG. 2. In other words, within the range, the through-hole 32 of the circuit board 3 stays engaged with a press-fitting portion (larger diameter portion) 21 having a diameter larger than the through-hole 32. As a result, even when the case 1 suffers heat or vibration and the circuit board 3 moves while the connector pin 2 is retained in the through-hole 32, the movement of the circuit board 3 is limited by the limiting member 15b and the fitting protruding portion 16.

The printed circuit board 3 is, as shown in FIG. 1, a rectangle plate body, which is slightly smaller than the rectangle of the case body 1a when seen as a plan view, and can be held in the case 1 in such a manner that the printed circuit board 3 is not brought into contact with the inner faces of the lateral walls of the case body 1a. In the printed circuit board 3, as shown in FIGs. 2 and 3, through-holes (insertion holes) 32 are formed. Into the through-hole 32, as will be described below, a press-fitting portion 21 of the connector pin 2 (see FIG. 2C) is inserted, to thereby connect the connector pin 2 to the printed circuit board 3 by press-fitting.

The connector pin 2 is a bar-shaped conductive member die-cut from a metal plate, which is bent in an L-shape. As shown in FIG. 1, the circuit board housing structure S of the present embodiment is provided with four connector pins 2. The number of the connector pin 2 is not limited to four, and any number can be appropriately selected. As shown in FIG. 3, an elbow portion of the connector pin 2 is embedded in the support portion 15a so that the connector pin 2 is supported on the bottom face 14 of the case body 1a. One straight portion of the connector pin 2 extends along the bottom face 14 of the case body 1a and protrudes into a space in the connector 11. As described above, this straight portion of the connector pin 2 is electrically connected to terminal pins (not shown) of the harness connector (not shown), when the harness connector is connected to the connector 11. As shown in FIG. 2A, the other straight portion of the connector pin 2 extends from the bottom face 14 to the opening 12 of the case body 1a. Near an end portion of this straight portion of the connector pin 2, the press-fitting portion 21 is formed, which is inserted in the through-hole 32 of the printed circuit board 3, as shown in FIG. 2C. A diameter of the press-fitting portion 21 is thicker than that of an axis portion 22 (which is thinner than an inner diameter of the through-hole 32), and still thicker than the inner diameter of the through-hole 32. In the press-fitting portion 21, an oval through-hole 23 is formed. When the press-fitting portion 21 is inserted in the through-hole 32, the through-hole 23 becomes more flattened, and the press-fitting portion 21 exerts spring property to push an inner face of the through-hole 32. In this manner, the press-fitting portion 21 serves as a larger diameter portion than the diameter of other portions of the connector pin 2.

The inner face of the through-hole 32 is plated with copper (copper plating 32a), and the copper plating 32a is electrically connected to the circuit pattern (not shown) of the printed circuit board 3. Therefore, when the press-fitting portion 21 of the connector pin 2 is inserted in the through-hole 32, the connector pin 2 and the printed circuit board 3 are connected by press-fitting. In other words, the printed circuit board 3 is supported by the connector pins 2 in the case body 1a, and at the same time, the circuit pattern (not shown) formed on the printed circuit board 3 and the connector pin 2 are electrically connected to each other.

In order to prevent electrical connection failure, it is desired that an exposed portion of the press-fitting portion 21 above the circuit board 3 protrude by the distance s or more, and that an exposed portion below the circuit board 3 protrude by the distance r or more (see FIG. 2B), taking effects of thermal expansion or the like into account. With this configuration, the circuit board 3 is supported at the through-holes 32 and held in the case 1 at a standard position in the case 1 (hereinafter, referred to as "board standard position"), where the circuit board 3 is not brought into contact with any of the case 1a and the lid 1b in an axial direction of the connector pin 2. In other words, the circuit board 3 in the case 1 is brought into contact only with the connector pin 2 and supported thereby. Therefore, the case 1, except the connector pin 2, does not interfere with the circuit board 3.

Accordingly, even when the case body 1a, the lid 1b and the circuit board 3 undergo thermal expansion and the volumes thereof increase, the circuit board 3 is not brought into contact with the case body 1a and the lid 1b, and thus the connections between the through-hole 32 and the connector pin 2 do not change. As a result, electric characteristics do not change either.

Next, a description is made with respect to a method for setting the circuit board 3 at the board standard position where the circuit board 3 is downward apart from the case 1 by the distance r and upward apart from the case 1 by the distance s, as shown in FIG. 2B.

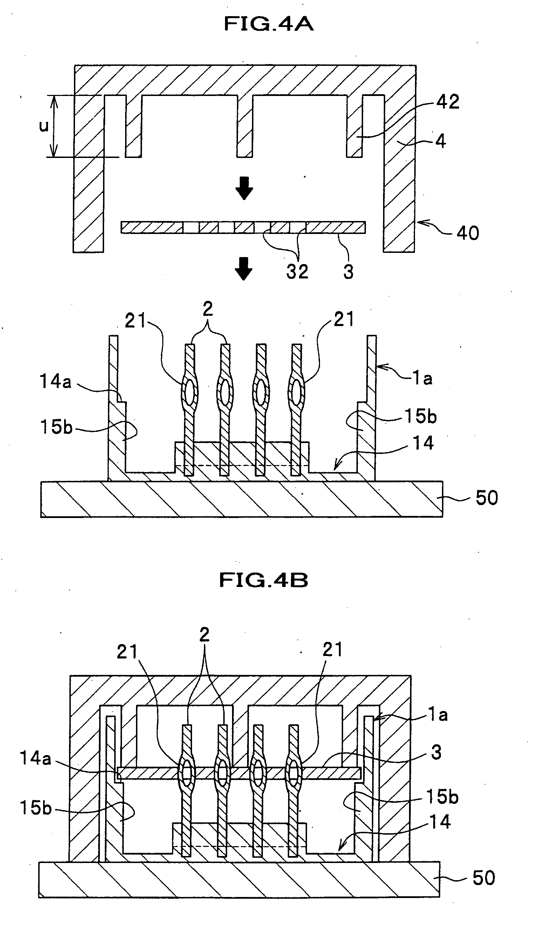

As shown in FIG. 4A, the circuit board 3 is pressed to the case body 1a mounted on a seating 50 from above, by a positioning member 40, to thereby place the circuit board 3 at the board standard position, as shown in FIG. 4B.

In this positioning, the positioning member 40 is used. The positioning member 40 has a frame body 4 larger than the case body 1a, and protruding portions 42 formed therein. Though the number of the protruding portion 42 is three in this embodiment, any number and width thereof can be appropriately selected. It should be noted that a magnitude of the depth of the frame body 4 is made larger than a magnitude of the height of the case body 1a. In addition, the protruding portion 42 protrudes from a bottom face of an upper plate of the frame body 4 by a distance u. Therefore, the height of the board standard position is set as a height obtained by subtracting the distance u from the height of an inner face of a lateral wall of the frame body 4.

Briefly, the case body 1a supporting the connector pins 2 therein is mounted on the seating 50. Then, the connector pins 2 are inserted in the through-holes 32, to thereby set the circuit board 3 in the case body 1a. The insertion into the through-holes 32 is limited by the press-fitting portions 21.

The frame body 4 of the positioning member 40 is placed over the case body 1a, and pressed until the bottom end face of the frame body 4 comes into contact with the seating 50, which allows the protruding portion 42 to push an upper face of the circuit board 3. As a result, the press-fitting portions 21 are inserted in the through-holes 32 while undergoing elastic deformation, and the circuit board 3 is pushed until the circuit board 3 comes to the board standard position. In this manner, the positioning of the circuit board 3 is completed, and after removing the positioning member 40, as shown in FIG. 1 or the like, the lid 1b is placed over the case body 1a and sealed, for example with adhesive or welding by laser processing.

Therefore, the circuit board 3 is held at the board standard position in the case 1 through the through-holes 32, where the circuit board 3 does not interfere with any of the case 1a and the lid 1b in the axial direction of the connector pin 2.

The distances r and s shown in FIG. 2B are determined in such a manner that the circuit board 3 is movable within the non-disengageable range that does not allow the through-hole 32 to disengage from the press-fitting portion 21. It should be noted that (1) preferably the non-disengageable range is determined so that the circuit board 3 is not brought into contact with any of the portions of the case 1 in the axial direction of the connector pin 2, other than the connector pins 2, after thermal expansion of the circuit board 3, the connector pin 2, the case body 1a or the lid 1b. In addition, it should be noted that (2) preferably the non-disengageable range is determined so that the holding power between the through-hole 32 and the press-fitting portion 21 gives contact resistance therebetween that falls within a specific range.

Next, effects of the circuit board housing structure S will be explained in a case where the case 1 suffers thermal expansion. As shown in FIG. 2B, the circuit board 3 is movable upward by the distance s and downward by the distance r. Therefore, when the lid 1b suffers thermal expansion and approaches the circuit board 3 by less than the distance s, the lid 1b never comes into contact with the circuit board 3. Likewise, when the case body 1a suffers thermal expansion and approaches the circuit board 3 by less than the distance r, the case body 1a never comes into contact with the circuit board 3. In other words, the spacing of the distance s or r serves as "play" that absorbs thermal expansion of the case 1. Therefore, in this case, it is preferred that the non-disengageable range falls in the category (1).

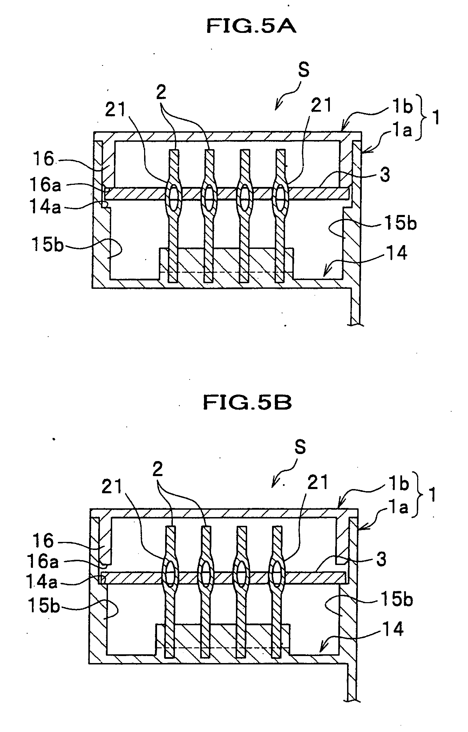

Next, referring to FIGs. 5A and 5B, effects of the circuit board housing structure S will be explained in a case where the circuit board 3 comes off from the board standard position, due to impact or vibration on the case 1.

As shown in FIG. 5A, when the circuit board 3 moves upward, the movement thereof is limited by the limiting face 16a. Therefore, the circuit board 3 (through-hole 32) never disengages from the connector pin 2 to lose electrical connections.

On the other hand, as shown in FIG. 5B, when the circuit board 3 moves downward, the movement thereof is limited by the limiting face 14a. Therefore, the electrical connections between the circuit board 3 (through-hole 32) and the connector pin 2 are always retained. In this case, it is preferred that the non-disengageable range falls in the category (2).

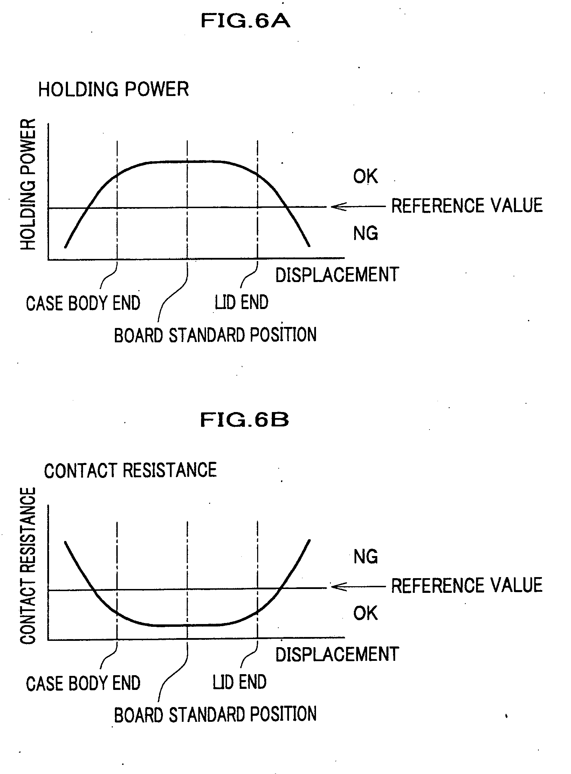

Next, referring to FIGs. 6A and 6B, a setting standard of the board standard position in the case of (2) will be described. It should be noted that, in the graphs shown in FIGs . 6A and 6B, for displacement taken as the horizontal axis, the left side in FIG. 6 corresponds to an inner side of the case body 1a, and the right side in FIG. 6 corresponds to a lid 1b-side.

Since a pressure applied to the through-hole 32 by elastic deformation of the press-fitting portion 21 becomes the holding power to hold the circuit board 3, the relationship between the holding power and the displacement of the circuit board 3 (displacement in the axial direction of the connector pin 2) is represented, for example, as shown in the graph of FIG. 6A.

When a center portion of the press-fitting portion 21 in the axial direction is connected to the through-hole 32, the holding power becomes largest, and becomes smaller when away from the center (to the left and right sides) in FIG. 6. Herein, a reference value of the holding power is determined by experiments or simulations, and a range of displacement is determined in such a manner that the holding power becomes equal to or larger than the reference value, preferably larger by a certain extent. Accordingly, the limiting face 16a of the fitting protruding portion (limiting member) 16 of the lid 1b (see, for example, FIG. 2) is set at the displacement indicated with "lid end" in the graph. The displacement value corresponds to the position indicated by the distance s in FIG. 2B. Likewise, the limiting face 14a of the case body 1a is set at the displacement indicated with the "case body end" in the graph. The displacement value corresponds to the position indicated by the distance r in FIG. 2B.

It should be noted that the relation between a holding power and a displacement in FIG. 6A is merely an example, and the relation is not limited to this graph. For example, the graph may have a notable peak of the holding power at the board standard position. In this case, the circuit board 3 is more stably held against vibrations.

As is apparent from FIG. 6B in light of FIG. 6A, contact resistance becomes lower at displacement with a larger holding power. Herein, the "contact resistance" means an electric resistance obtained when the press-fitting portion 21 is in contact with the through-hole 32. In other words, when the contact resistance is lower, the electric resistance becomes lower and impedance matching becomes better. Therefore, when the contact resistance is also taken into account, connector performance is considered to be better when the center portion of the press-fitting portion 21 is in contact with the through-hole 32, i.e., when the circuit board 3 is at the board standard position. Accordingly, it is preferred to set the board standard position while both the holding power and the contact resistance are taken into consideration.

As described above, according to the present embodiment, even when the case body 1a, the lid 1b and the circuit board 3 undergo thermal expansion by heat and the volumes thereof increase, the circuit board 3 is not brought into contact with the case body 1a and the lid 1b, and thus the connections between the through-hole 32 and the connector pin 2 do not change. Therefore, electric characteristics do not change, and a stable connection state can be retained. As a result, as compared with the conventional circuit board housing structure, there can be provided a circuit board housing structure S exhibiting stable electric characteristics against heat.

The embodiments of the present invention have been described above. However, the present invention is not limited to the above embodiments, and it is a matter of course that the above embodiments may be properly modified.

In the above-described embodiment, the case body 1a has a step-shaped limiting member 15b. However, the limiting member 15b may be in a shape of a stage which can receive the moving printed circuit board 3. For the receiving stage, any arrangement, number and shape can be appropriately selected.

In the above-described embodiment, the circuit board housing structure S was explained supposing that no resin molding is applied to the printed circuit board 3. However in the present invention, resin molding may be applied to the printed circuit board 3.

### (Second embodiment)

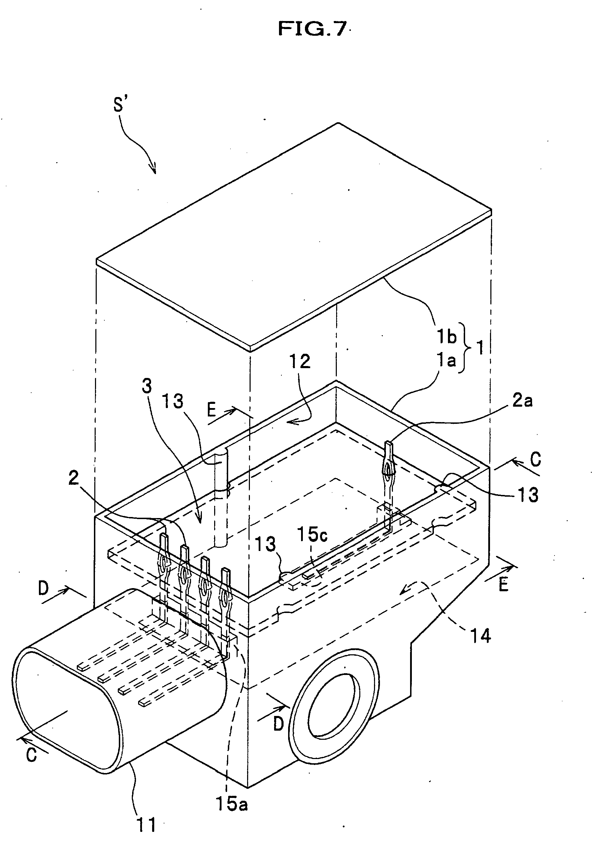

Next, a circuit board housing structure according to a second embodiment of the present invention will be described in detail with reference to FIGs. 7 - 11. In the following description, components which are the same as those illustrated in the first embodiment are designated with the same reference characters, and thus a duplicate description is omitted.

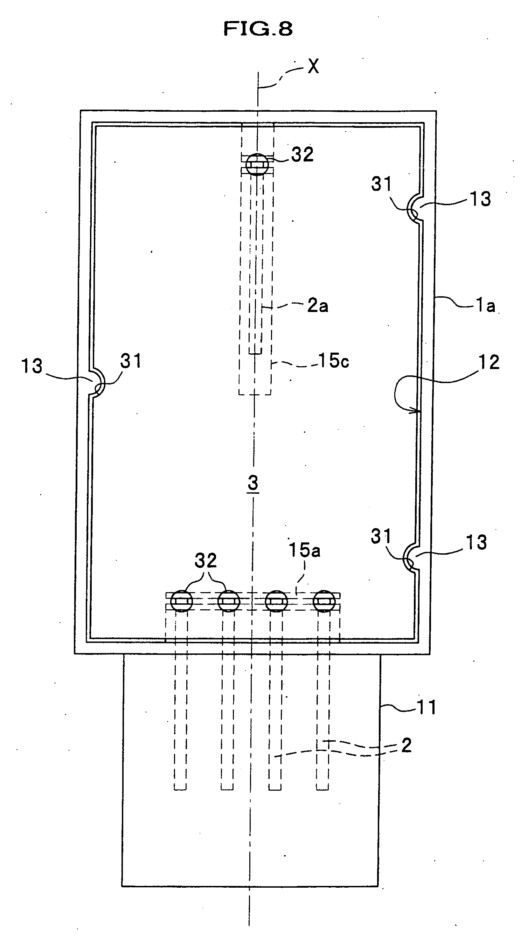

As shown in FIGs. 7 and 8, in the circuit board housing structure S' , the case body 1a further includes a pin member 2a. On inner faces on long side of the rectangle (inner faces of wide lateral walls) of the case body 1a, ribs 13 are formed, which extends from the bottom face 14 to the opening 12 of the case body 1a (see FIG. 7), and has a semicircular cross section. In this embodiment, the inner face of one of the wide lateral walls has a single rib 13 at a center portion thereof, and the inner face of the other wide lateral wall has two parallelly arranged ribs 13. It should be noted that the cross sectional shape of the rib 13 is not limited to a semicircle, and any shape can be appropriately selected. The rib 13 may not be continuously extends from the bottom face 14 to the opening 12.

It should be noted that, in the present embodiment, the lid 1b is in a form of a simple plate. However, the lid 1b may have a fitting protruding portion as described in the first embodiment, and in this case, the fitting protruding portion is formed to have a shape that does not interfere with the rib 13.

On the bottom face 14 of the case body 1a (see FIG. 7), a support portion 15c for supporting the pin member 2a on the bottom face 14 of the case body 1a is further formed. The support portion 15c is in a shape of a bar extending on the bottom face 14 of the case body 1a, along a center line X in a longitudinal direction of the case body 1a when seen as a plan view, from the short side without the connector 11 to the center portion.

As shown in FIG. 7, the printed circuit board 3 is a rectangular plate body, and as shown in FIG. 8, the printed circuit board 3 has recess portions 31 formed on the long side of the rim thereof. Specifically, the recess portions 31 are provided at positions corresponding to the ribs 13 formed in the case body 1a, each of which recess portion has a cross section corresponding to a cross section of the rib 13 so as to accommodate the rib. In this embodiment, one of the rims on the long side of the printed circuit board 3 has a single recess portion 31 at a center portion thereof, and the other long rim has two recess portions 31 side by side. When the recess portion 31 accommodates the rib 13, the printed circuit board 3 is appropriately positioned in the case body 1a. It should be noted that, in the present embodiment, the number and arrangement of the recess portions 31 (ribs 13) are not symmetrical with respect to the center line X, and when the printed circuit board 3 is placed in the case body 1a, it becomes possible to easily identify the proper side (upper side/lower side) and proper direction (right/left) of the printed circuit board 3.

In addition, as shown in FIGs . 8 and 9, the printed circuit board 3 further has a through-hole 32 for receiving the pin member 2a.

The pin member 2a and the connector pin 2 have the same shape, and in the present embodiment, the same member is used for the connector pin 2 and the pin member 2a. In the circuit board housing structure S' of the present embodiment, the number of the pin member 2a is one, as shown in FIG. 7. It should be noted that the number of the pin member 2a is not limited to one, and can be appropriately determined.

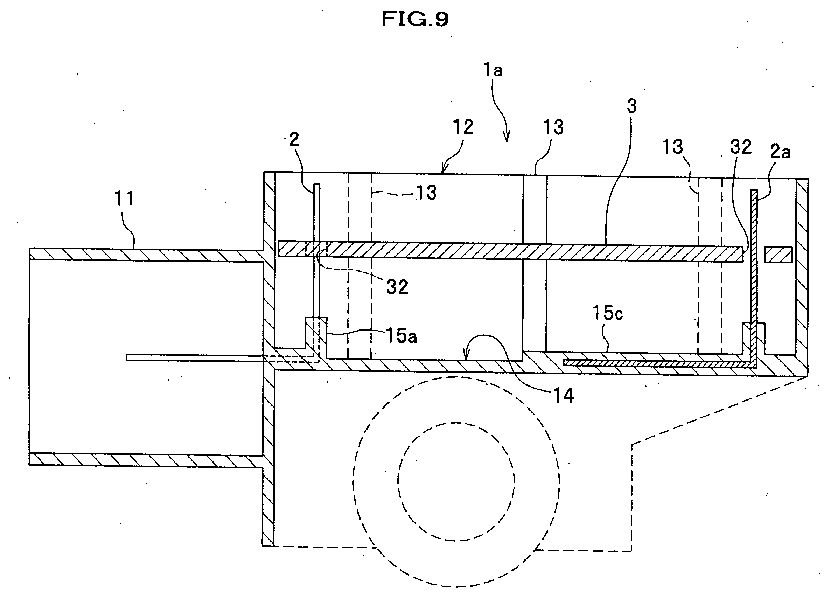

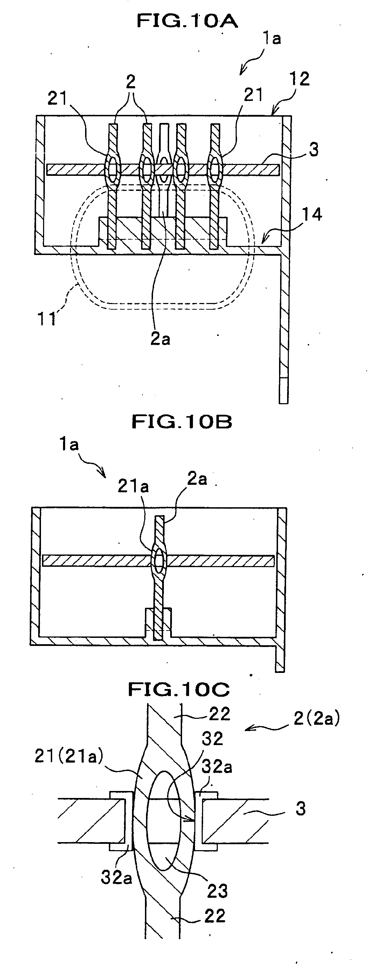

Since one straight portion of the pin member 2a as well as an elbow portion is embedded in the support portion 15c, the pin member 2a is supported by the bottom face 14 of the case body 1a. It should be noted that, this embedded straight portion of the pin member 2a extends along the center line X from the short side without the connector 11 to the center portion, as shown in FIG. 8. The other straight portion of the pin member 2a extends along the inner face of the narrow lateral wall of the case body 1a without the connector 11, as shown in FIG. 9, from the bottom face 14 to the opening 12 of the case body 1a. As shown in FIG. 10B, like in the connector pin 2, near an end portion of this straight portion of the pin member 2a, a press-fitting portion 21a is formed, which is inserted in the through-hole 32 of the printed circuit board 3, as shown in FIG. 10C. When the press-fitting portion 21a is inserted in the through-hole 32, the press-fitting portion 21a pushes an inner face of the through-hole 32, and thus the printed circuit board 3 is also supported by the pin member 2a in the case body 1a. It should be noted that in the present embodiment, a copper plating 32a on the through-hole 32 into which the pin member 2a is inserted is not electrically connected with the circuit pattern (not shown) of the printed circuit board 3. In other words, though the pin member 2a is fixed to the printed circuit board 3 by press-fitting in the same manner as the connector pin 2, the pin member 2a serves as a dummy pin which merely supports the printed circuit board 3, unlike the connector pin 2.

Next, effects of the circuit board housing structure S' according to the present embodiment will be described with reference to the drawings. In the drawings to be referred, FIG. 11A is a schematic view of a part of the circuit board housing structure according to the second embodiment showing a state in which the connector pins and the pin member are fixed to the printed circuit board, FIG. 11B is a schematic view of a part of the conventional circuit board housing structure according to a comparative embodiment showing a state in which the connector pins are fixed to the printed circuit board, and FIG. 11C is a schematic view of a part of the conventional circuit board housing structure according to another comparative embodiment showing a state in which the connector pins are fixed to the printed circuit board.

In the circuit board housing structure S' , as shown in FIG. 11A, one end portion of the printed circuit board 3 held in the case body 1a (see FIG. 7) is supported by the case body 1a through the connector pins 2. The other end portion of the printed circuit board 3 is supported by the case body 1a through the pin member 2a. As a result, even when the case body 1a, the lid 1b and the circuit board 3 undergo thermal expansion by heat and the volumes thereof increase, the circuit board 3 is not brought into contact with the case body 1a and the lid 1b, and thus the connections between the through-hole 32 and the connector pin 2 do not change. Therefore, electric characteristics do not change. In addition, since the printed circuit board 3 is supported at both end portions thereof, a cantilever structure is no longer present, and thus warping due to vibrations and the like can be prevented.

As shown in FIG. 11B, in the conventional circuit board housing structure Sa according to a comparative embodiment, the printed circuit board 3 is cantilevered by the connector pins 2. Therefore, in the circuit board housing structure Sa, it is necessary to provide a bottom face of the case (not shown) for holding the printed circuit board 3 with a support stage for supporting the printed circuit board 3 (not shown), in order to prevent the printed circuit board 3 from warping. Moreover, even though the circuit board housing structure Sa has the support stage, it cannot prevent the printed circuit board 3 from warping in a direction away from the support stage.

On the other hand, in the circuit board housing structure S' according to the embodiment shown in FIG. 11A, both end portions of the printed circuit board 3 are supported by the connector pins 2 and the pin member 2a. Therefore, unlike the conventional circuit board housing structure Sa shown in FIG. 11B, the printed circuit board 3 is efficiently prevented from being warped, without providing the case with a support stage. Since there is no need to provide the circuit board housing structure S' with a support stage, a space in the case body 1a (see FIG. 7) can be efficiently utilized. Accordingly, in the circuit board housing structure S' with no support stages, a structure of the case body 1a can be made simpler, and thus the production of the case body 1a can be facilitated, as compared with the circuit board housing structure Sa.

For a structure in which both end portions of the printed circuit board 3 are supported, there may be a circuit board housing structure Sb in which both end portions of the printed circuit board 3 are supported by the connector pins 2 and the connector pins 2b, as shown in FIG. 11C. However in this circuit board housing structure Sb as a comparative embodiment, if end portions of the connector pins 2 and connector pins 2b are arranged in one connector 11 (see FIG. 7), connection distance from the printed circuit board 3 to the connector 11 are different for the connector pins 2 and for the connector pins 2b, and thus the shapes of the connector pin 2 and that of the connector pin 2b should be different. As a result, more components are required for forming the circuit board housing structure Sb, leading to a higher cost for producing the circuit board housing structure Sb, and to lower production efficiency. On the other hand, in the circuit board housing structure S' according to the embodiment shown in FIG. 11A, the connector pin 2 and the pin member 2a supporting the printed circuit board 3 have the same shape, and thus the same member can be used. Therefore, a production cost of the circuit board housing structure S' can be reduced, and production efficiency can be improved, and still more, larger packing area can be secured.

Further, in the circuit board housing structure S' according to the present embodiment, the connector pin 2 and the pin member 2a for supporting the printed circuit board 3 have the same shape. Therefore, by arranging the connector pins 2 and the pin member 2a on the bottom face 14 (see FIG. 7) of the case body 1a, the printed circuit board 3 can be easily arranged in parallel with the bottom face 14.

Also in this circuit board housing structure S', the pin member 2a is not electrically connected to the circuit pattern of the printed circuit board 3. Therefore, the pin member 2a can be arranged regardless of the configuration of the circuit pattern. As a result, design freedom of the circuit pattern on the printed circuit board 3 is enhanced.

As shown in FIG. 8, in this circuit board housing structure S' , by accommodating the rib 13 of the case body 1a in the recess portion 31 of the printed circuit board 3, the printed circuit board 3 is properly positioned relative to the case body 1a. As a result, the printed circuit board 3 is properly positioned relative to the connector pins 2 and the pin member 2a, which facilitates connections of the connector pins 2 and the pin member 2a to the printed circuit board 3 by press-fitting.

In the above-described embodiment, a support stage for supporting the printed circuit board 3 is not provided on the bottom face 14 of the case body 1a. However in the present invention, such a support stage may be provided. Any position, number and shape of the support stage can be appropriately selected.

Also in the above-described embodiment, the pin member 2a and the circuit pattern of the printed circuit board 3 are not electrically connected. However in the present invention, the pin member 2a and the circuit pattern may be electrically connected.

In the above-described embodiment, the circuit board housing structure S' was explained supposing that no resin molding is applied to the printed circuit board 3. However in the present invention, resin molding may be applied to the printed circuit board 3.

## Claims

1. A circuit board housing structure (S) comprising:
- a circuit board (3) having insertion holes (32) on one end portion thereof;
- connector pins (2) each having a larger diameter portion (21) than a diameter of the insertion hole (32);
- the larger diameter portion (21) of the connector pins (2) having elasticity; and
- a case (1) comprising a case body (1a) for supporting the connector pins (2) and a lid (1b) for closing an opening of the case (1);
- the connector pins (2) being arranged along the inner face on one side of the case body (1a);
**characterised in that**
the circuit board (3) is supported by the connector pins (2) with a holding power in a radial direction exerted by the larger diameter portion (21) when the larger diameter portion (21) is inserted in the insertion hole (32),
so that the circuit board (3) is held at a standard position in the case (1) where it does not come into contact in an axial direction of the connector pin (2) with any of the case body (1a) and the lid (1b) and so that the circuit board (3) is supported only by the connector pins (2).

2. The circuit board housing structure (S) according to Claim 1, wherein the circuit board (3) is movable within a non-disengageable range that does not allow the insertion hole (32) of the circuit board (3) to disengage from the larger diameter portion (21) of the connector pin (2).

3. The circuit board housing structure (S) according to Claim 2, wherein the non-disengageable range is a range in which the circuit board (3) does not interfere with any of the case body (1a) and the lid (1b) in an axial direction of the connector pin (2), even when at least one of the circuit board (3), the connector pin (2), the case body (1a) and the lid (1b) undergoes thermal expansion.

4. The circuit board housing structure (S) according to Claim 2 to 3, wherein the non-disengageable range is a range in which the holding power between the insertion hole (32) and the larger diameter portion (21) of the connector pin (2) gives contact resistance therebetween that falls within a specific range.

5. The circuit board housing structure (S) according to any one of Claims 2 to 4, wherein at least one of the case body (1a) and the lid (1b) is provided with a limiting member for limiting a movement of the circuit board (3) within the non-disengageable range.

6. The circuit board housing structure (S) according to any one of Claim 1 to 5, wherein the circuit board (3) further has a second insertion hole (32) on the other end portion of the circuit board (3), a pin member (2a) having the same shape as that of the connector pin (2) is provided in the case (1), and a larger diameter portion (21) of the pin member (2a) is inserted in the second insertion hole (32) to support the circuit board (3) in the case (1).

7. The circuit board housing structure (S) according to Claim 6, wherein the pin member (2a) is not electrically connected with a circuit pattern formed on the circuit board (3).

8. The circuit board housing structure (S) according to Claim 1 to 7, wherein ribs (13) for positioning the circuit board (3) are formed on inner faces of lateral walls of the case, and recess portions (31) are formed in a rim of the circuit board (3), each recess portion (31) having a cross section corresponding to a cross section of the rib (13) for accommodating the rib (13).

## Patentansprüche

1. Leiterplatten-Gehäuseanordnung (S), umfassend:
- eine Leiterplatte (3) mit Einführungslöchern (32) an ihrem einen Endbereich,
- Verbindungsstifte (2), die jeweils einen Bereich (21) mit einem Durchmesser aufweisen, der größer ist als ein Durchmesser des Einführungslochs (32),
- wobei der Bereich (21) größeren Durchmessers der Verbindungsstifte (2) eine Elastizität aufweist,
- und ein Gehäuse (1), enthaltend einen Gehäusekörper (1a) zum Aufnehmen der Verbindungsstifte (2) und einen Deckel (1b) zum Schließen einer Öffnung des Gehäuses (1),
- wobei die Verbindungsstifte (2) längs der inneren Fläche auf einer Seite des Gehäusekörpers (1a) angeordnet sind,
**dadurch gekennzeichnet,**
**dass** die Leiterplatte (3) durch die Verbindungsstifte (2) mit einer durch den Bereich (21) größeren Durchmessers in einer radialen Richtung ausgeübten Haltekraft getragen ist, wenn der Bereich (21) größeren Durchmessers in das Einführungsloch (32) eingeführt ist, derart, dass die Leiterplatte (3) in dem Gehäuse (1) in einer Standardposition gehalten wird, in der sie in einer axialen Richtung des Verbindungsstiftes (2) nicht mit irgendeiner der den Gehäusekörper (1a) und den Deckel (1b) umfassenden Einrichtungen in Kontakt gelangt, und derart, dass die Leiterplatte (3) lediglich durch die Verbindungsstifte (2) getragen ist.

2. Leiterplatten-Gehäuseanordnung (S) nach Anspruch 1, wobei die Leiterplatte (3) innerhalb eines nicht lösbaren Bereichs bewegbar ist, der dem Einführungsloch (32) der Leiterplatte (3) nicht ermöglicht, sich aus dem Bereich (21) größeren Durchmessers des Verbindungsstiftes (2) zu lösen.

3. Leiterplatten-Gehäuseanordnung (S) nach Anspruch 2, wobei der nicht lösbare Bereich ein Bereich ist, in welchem die Leiterplatte (3) sogar dann nicht auf irgendeine der den Gehäusekörper (1a) und den Deckel (1b) umfassenden Einrichtungen in einer axialen Richtung des Verbindungsstiftes (2) störend einwirkt, wenn zumindest eine der die Leiterplatte (3), den Verbindungsstift (2), den Gehäusekörper (1a) und den Deckel (1b) umfassenden Einrichtungen einer thermischen Ausdehnung ausgesetzt ist.

4. Leiterplatten-Gehäuseanordnung (S) nach Anspruch 2 bis 3, wobei der nicht lösbare Bereich ein Bereich ist, in welchem die Haltekraft zwischen dem Einführungsloch (32) und dem Bereich (21) größeren Durchmessers des Verbindungsstiftes (2) einen in einen bestimmten Bereich fallenden Kontaktwiderstand dazwischen liefert.

5. Leiterplatten-Gehäuseanordnung (S) nach einem der Ansprüche 2 bis 4, wobei zumindest eine der den Gehäusekörper (1a) und den Deckel (1b) umfassenden Einrichtungen mit einem Begrenzungsglied zum Begrenzen einer Bewegung der Leiterplatte (3) innerhalb des nicht lösbaren Bereiches versehen ist.

6. Leiterplatten-Gehäuseanordnung (S) nach einem der Ansprüche 1 bis 5, wobei die Leiterplatte (3) ferner ein zweites Einführungsloch (32) an dem anderen Endbereich der Leiterplatte (3) aufweist,
wobei ein Stiftglied (2a), welches dieselbe Form aufweist wie die des Verbindungsstiftes (2), in dem Gehäuse (1) vorgesehen ist
und wobei ein Bereich (21) größeren Durchmessers des Stiftgliedes (2a) in das zweite Einführungsloch (32) eingeführt ist, um die Leiterplatte (3) in dem Gehäuse (1) aufzunehmen bzw. zu tragen.

7. Leiterplatten-Gehäuseanordnung (S) nach Anspruch 6, wobei das Stiftglied (2a) mit einem auf der Leiterplatte (3) gebildeten Schaltungsmuster elektrisch nicht verbunden ist.

8. Leiterplatten-Gehäuseanordnung (S) nach Anspruch 1 bis 7, wobei Rippen (13) zum Positionieren der Leiterplatte (3) an inneren Flächen von Seitenwänden des Gehäuses gebildet sind,
wobei Ausnehmungsbereiche (31) in einem Rand der Leiterplatte (3) gebildet sind und wobei jeder Ausnehmungsbereich (31) einen einem Querschnitt der Rippe (13) entsprechen Querschnitt zur Aufnahme der Rippe (13) aufweist.

## Revendications

1. Structure de logement de carte de circuit (S) comprenant :
- une carte de circuit (3) ayant des trous d'insertion (32) sur une partie d'extrémité de celle-ci ;
- des broches de connecteur (2) ayant chacune une partie (21) de diamètre supérieur à un diamètre du trou d'insertion (32) ;
- la partie de diamètre supérieur (21) des broches de connecteur (2) ayant une élasticité ; et
- un boîtier (1) comprenant un corps de boîtier (1a) pour supporter les broches de connecteur (2) et un couvercle (1b) pour fermer une ouverture du boîtier (1) ;
- les broches de connecteur (2) étant agencées le long de la face intérieure sur un côté du corps de boîtier (1a) ;
**caractérisée en ce que**
la carte de circuit (3) est supportée par les broches de connecteur (2) avec un pouvoir de rétention dans une direction radiale exercé par la partie de diamètre supérieur (21) lorsque la partie de diamètre supérieur (21) est insérée dans le trou d'insertion (32),
de sorte que la carte de circuit (3) soit maintenue à une position standard dans le boîtier (1) pour qu'elle n'entre pas en contact dans une direction axiale de la broche de connecteur (2) ni avec le corps de boîtier (1a) ni avec le couvercle (1b) et de sorte que la carte de circuit (3) soit supportée uniquement par les broches de connecteur (2).

2. Structure de logement de carte de circuit (S) selon la revendication 1, dans laquelle la carte de circuit (3) peut être déplacée dans une plage sans mise hors prise qui ne permet pas au trou d'insertion (32) de la carte de circuit (3) de se dégager de la partie de diamètre supérieur (21) de la broche de connecteur (2).

3. Structure de logement de carte de circuit (S) selon la revendication 2, dans laquelle la plage sans mise hors prise est une plage dans laquelle la carte de circuit (3) n'interfère ni avec le corps de boîtier (1a) ni avec le couvercle (1b) dans une direction axiale de la broche de connecteur (2), même lorsqu'au moins l'un de la carte de circuit (3), de la broche de connecteur (2), du corps de boîtier (1a) et du couvercle (1b) subit une expansion thermique.

4. Structure de logement de carte de circuit (S) selon l'une quelconque des revendications 2 à 3, dans laquelle la plage sans mise hors prise est une plage dans laquelle le pouvoir de rétention entre le trou d'insertion (32) et la partie de diamètre supérieur (21) de la broche de connecteur (2) donne une résistance de contact entre ceux-ci qui se trouve dans une plage spécifique.

5. Structure de logement de carte de circuit (S) selon l'une quelconque des revendications 2 à 4, dans laquelle au moins l'un du corps de boîtier (1a) et du couvercle (1b) est pourvu d'un élément de limitation pour limiter un mouvement de la carte de circuit (3) dans la plage sans mise hors prise.

6. Structure de logement de carte de circuit (S) selon l'une quelconque des revendications 1 à 5, dans laquelle la carte de circuit (3) a en outre un deuxième trou d'insertion (32) sur l'autre partie d'extrémité de la carte de circuit (3), un élément de broche (2a) ayant la même forme que celle de la broche de connecteur (2) est disposé dans le boîtier (1), et une partie de diamètre supérieur (21) de l'élément de broche (2a) est insérée dans le deuxième trou d'insertion (32) pour supporter la carte de circuit (3) dans le boîtier (1).

7. Structure de logement de carte de circuit (S) selon la revendication 6, dans laquelle l'élément de broche (2a) n'est pas connecté électriquement à un motif de circuit formé sur la carte de circuit (3).

8. Structure de logement de carte de circuit (S) selon l'une quelconque des revendications 1 à 7, dans laquelle des nervures (13) pour positionner la carte de circuit (3) sont formées sur des faces intérieures des parois latérales du boîtier, et des parties d'évidement (31) sont formées dans un bord de la carte de circuit (3), chaque partie d'évidement (31) ayant une coupe transversale correspondant à une coupe transversale de la nervure (13) pour accueillir la nervure (13).
